# EUROPEAN PATENT APPLICATION

(11) **EP 4 844 015 A1**
(43) Date of publication of application: **25.11.2026**
(21) Application number: 25741971.3
(22) Date of filing: 16.01.2025
(51) Int. Cl.: C08G 77/46, C08G 77/38, C08L 63/00, C08L 101/00, H01L 23/29, H01L 23/31

(54) **CO-MODIFIED SILICONE**

(30) Priority: 16.01.2024 JP 2024004702
(71) Applicant: Dow Toray Co., Ltd., Tokyo 140-8617 (JP)
(72) Inventor: SATO OFUCHI, Momoko, Ichihara-shi, Chiba 299-0108 (JP); SOUDA, Tatsuo, Ichihara-shi, Chiba 299-0108 (JP); YAMASHITA, Satoshi, Ichihara-shi, Chiba 299-0108 (JP); TANIGUCHI, Hiroko, Ichihara-shi, Chiba 299-0108 (JP); TAN, Liyi, Ichihara-shi, Chiba 299-0108 (JP); HORI, Seiji, Ichihara-shi, Chiba 299-0108 (JP)
(74) Representative: Elkington and Fife LLP
(86) International application number: PCT/JP2025/001073
(87) International publication number: WO 2025/154746

(57) **Abstract**

To provide a novel co-modified silicone and the like. A co-modified silicone, comprising, in a molecule: a phenolic hydroxyl group-containing structure; and a polyether structure.

## Description

### TECHNICAL FIELD

The present invention relates to: a co-modified silicone; an additive for an organic resin, the additive containing the co-modified silicone; a curable resin composition; a cured product obtained by curing the co-modified silicone; a semiconductor device containing the cured product; and a method for manufacturing a semiconductor device.

### BACKGROUND ART

In recent years, electronic devices such as mobile phones, smartphones, ultra-thin liquid crystal displays, plasma TVs, and lightweight laptops have decreased in size. Consequently, high-density integration and high-density mounting of electronic components, such as semiconductor devices used in these electronic devices, are advancing. Herein, the resin materials used in these electronic components are required to have a low coefficient of thermal expansion and a low modulus of elasticity in order to prevent warping after molding and release between members during a solder reflow process, due to thermal stress during manufacturing and use. Furthermore, heat resistance is required from the perspective of preventing manufacturing problems and ensuring the reliability of electronic components. For example, Patent Document 1 describes a study on increasing the amount of filler in epoxy resins in order to reduce thermal stress. While increasing the amount of filler can reduce the coefficient of thermal expansion of epoxy resins, this method may not be sufficient to suppress warping when a support body surface area is large, such as in wafer-level or panel-level packages. Furthermore, the increased modulus of elasticity of the epoxy resins and resulting decrease in the strength thereof can lead to problems such as the destruction of Si chips or substrate during manufacturing processes like solder reflow or during use, including heat cycle testing.
Furthermore, Patent Documents 2 and 3 disclose another method for reducing thermal stress, which involves adding epoxy-modified silicone to an epoxy resin to lower the modulus of elasticity thereof. While this method is effective in reducing thermal stress, the method was not sufficient in reducing the coefficient of thermal expansion (coefficient of linear expansion). In particular, the reduction in the coefficient of thermal expansion at higher temperatures than the glass transition temperature was insufficient.
Furthermore, modified silicones containing polyether structures are sometimes used from the perspective of miscibility with epoxy resins, but these modified silicones have the problem of lacking heat resistance. Epoxy resin molding and solder reflow processes can expose the material to temperatures as high as 175°C, and therefore, the added silicone preferably also has heat resistance. Generally, it is known that heat resistance can be improved by replacing methyl groups on siloxane with phenyl groups, but the problem was that the silicone additive itself became highly viscous.

### RELATED ART DOCUMENTS

### Patent Documents

Patent Document 1: JP 2013-010940 A
Patent Document 2: JP 2020-023643 A
Patent Document 3: WO 2021/149727 A1

### SUMMARY OF THE INVENTION

### PROBLEM TO BE SOLVED BY THE INVENTION

Under such circumstances, the present invention provides a novel co-modified silicone and the like.

### MEANS FOR SOLVING THE PROBLEM

The present invention provides the following co-modified silicones and the like.
[1] A co-modified silicone, including, in a molecule: a phenolic hydroxyl group-containing structure; and a polyether structure.
[2] The co-modified silicone according to [1], wherein the viscosity at 25°C is in the range from 50 to 100,000 mPa·s.
[3] The co-modified silicone according to [1] or [2], which is expressed by average compositional formula (1):

   R¹ₐR²_{b}R³_{c}R⁴_{d}SiO_{(4 - a - b - c - d)/2},

   wherein
   in the abovementioned average compositional formula (1), R¹ each independently represents a hydrogen atom or a monovalent hydrocarbon group with 1 to 18 carbon atoms, R² each independently represents a group having a phenolic hydroxyl group expressed by general formula (2) below, R³ each independently represents a group containing a polyether structure expressed by general formula (3) below, and R⁴ each independently represents a monovalent hydrocarbon group with 1 to 18 carbon atoms or a silicon-containing organic group; and
   a, b, c, and d satisfy the relationships of b > 0, c > 0, a ≥ 0, d ≥ 0, and a + b + c + d = 4. 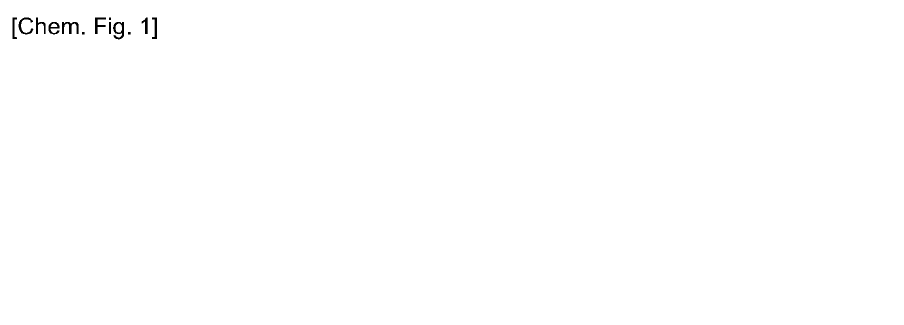 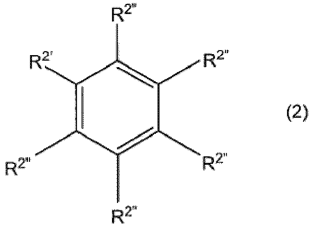
   (In general formula (2),
   R^{2'} represents a divalent hydrocarbon group with 1 to 18 carbon atoms bonded to a silicon atom, and
   R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group.) 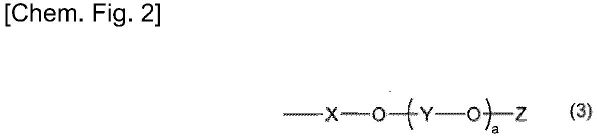
   (In general formula (3),
   X represents a divalent hydrocarbon group with 1 to 18 carbon atoms,
   Y represents an alkylene group with 1 to 6 carbon atoms,
   a represents a number from 5 and 100, and
   Z represents a hydrogen atom, a monovalent hydrocarbon group with 1 to 12 carbon atoms, or an acyl group with 1 to 12 carbon atoms.)
[4] The co-modified silicone according to any one of [1] to [3], which is expressed by average compositional formula (2):
   (R¹₂R'SiO_{1/2})ₐ(R²R'SiO_{2/2})_{b}(R³R'SiO_{2/2})_{b'}(R⁴R'SiO_{2/2})_{b"}(R'SiO_{3/2})_{c}(SiO_{4/2})_{d}, wherein in the abovementioned average compositional formula (2), R¹ each independently represents a hydrogen atom or a monovalent hydrocarbon group with 1 to 18 carbon atoms, R² each independently represents a group having a phenolic hydroxyl group expressed by general formula (2) below, R³ each independently represents a group containing a polyether structure expressed by general formula (3) below, R⁴ each independently represents a monovalent hydrocarbon group with 1 to 18 carbon atoms or a silicon-containing organic group, and R' each independently represents one of R¹, R², R³, or R⁴; and
   a, b, b', b", c, and d satisfy the relationships of b > 0, b' > 0, a ≥ 0, b" ≥ 0, c ≥ 0, d ≥ 0, and 20 ≤ a + b + b' + b" + c + d ≤ 1000. 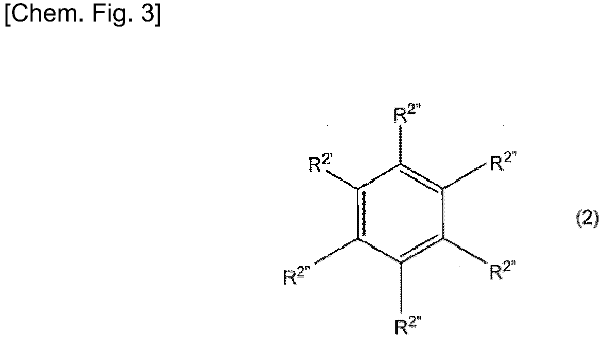
   (In general formula (2),
   R^{2'} represents a divalent hydrocarbon group with 1 to 18 carbon atoms bonded to a silicon atom, and
   R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group.) 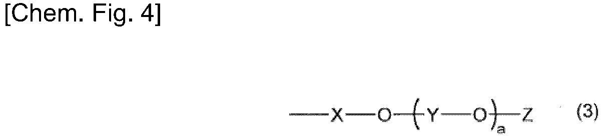
   (In general formula (3),
   X represents a divalent hydrocarbon group with 1 to 18 carbon atoms,
   Y represents an alkylene group with 1 to 6 carbon atoms, a represents a number from 5 and 100, and
   Z represents a hydrogen atom, a monovalent hydrocarbon group with 1 to 12 carbon atoms, or an acyl group with 1 to 12 carbon atoms.)
[5] The co-modified silicone according to any one of [1] to [4], including a structure expressed by the following general formula (1). 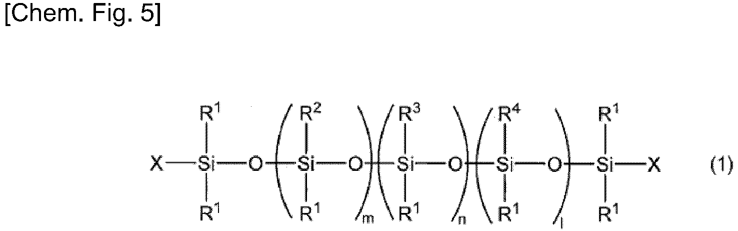 (In general formula (1),
   R¹ each independently represents a hydrogen atom or a monovalent hydrocarbon group with 1 to 18 carbon atoms,
   R² each independently represents a group having a phenolic hydroxyl group expressed by general formula (2) below,
   R³ each independently represents a group containing a polyether structure expressed by general formula (3) below,
   R⁴ each independently represents a monovalent hydrocarbon group or silicon-containing organic group with 1 to 18 carbon atoms,
   X each independently represents any one of R¹, R², R³, or R⁴,
   m represents a number from 0 to 100, where if m is 0, at least one X is R²,
   n represents a number from 0 to 100, where if n is 0, at least one X is R³,
   when m = n = 0 is satisfied, two Xs in a molecule are R² and R³, respectively, and l represents a number from 0 to 1000.) 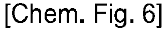 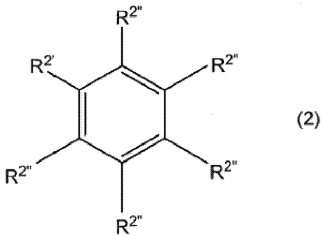
   (In general formula (2),
   R^{2'} represents a divalent hydrocarbon group with 1 to 18 carbon atoms bonded to a silicon atom, and
   R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group.) 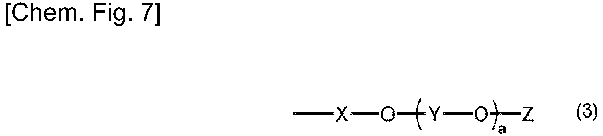
   (In general formula (3),
   X represents a divalent hydrocarbon group with 1 to 18 carbon atoms,
   Y represents an alkylene group with 1 to 6 carbon atoms,
   a represents a number from 5 and 100, and
   Z represents a hydrogen atom, a monovalent hydrocarbon group with 1 to 12 carbon atoms, or an acyl group with 1 to 12 carbon atoms.)
[6] An additive for an organic resin, the additive including the co-modified silicone according to any one of [1] to [5].
[7] The additive for an organic resin according to [6], wherein the organic resin includes an epoxy resin.
[8] A curable resin composition, including the co-modified silicone according to any one of [1] to [5].
[9] The curable resin composition according to [8], wherein the curable resin includes an epoxy resin.
[10] A cured product obtained by curing the curable resin composition according to [8] or [9].
[11] A semiconductor device, including the cured product according to [10].
[12] A method for manufacturing a semiconductor device, the method including curing the curable resin composition according to [8] or [9].

### EFFECT OF THE INVENTION

According to one aspect of the present invention, a co-modified silicone is provided, which is capable of providing an additive for an organic resin or a curable resin composition that exhibits excellent fluidity (flowability) during molding and can impart excellent heat resistance to a cured product. According to one aspect of the present invention, a co-modified silicone is provided, which is capable of providing an additive for an organic resin or a curable resin composition that is capable of reducing the modulus of elasticity of a cured product.
According to one aspect of the present invention, a co-modified silicone is provided, which is capable of providing an additive for an organic resin or a curable resin composition that is capable of reducing the coefficient of linear expansion of a cured product.

### DESCRIPTION OF THE PREFERRED EMBODIMENTS

For the numerical ranges described in the present specification, the upper and lower limits can be combined as desired. For example, when the numerical range is described as "preferably 30 to 100, more preferably 40 to 80", the ranges "30 to 80" and "40 to 100" are also included in the numerical range described in the present specification. Furthermore, for example, when the numerical range is described as "preferably 30 or more, more preferably 40 or more, and preferably 100 or less, more preferably 80 or less", the ranges "30 to 80" and "40 to 100" are also included in the numerical range described in the present specification.
In addition, as a numerical range described in the present specification, for example, the statement "60 to 100" means that the range is "60 or more and 100 or less".

### 1. Co-modified Silicone

In one aspect, the present invention provides a co-modified silicone (hereinafter also referred to as "the compound of the present invention"). The compound of the present invention contains a phenolic hydroxyl group-containing structure and a polyether structure in a molecule. The co-modified silicone containing both of these structures in a molecule can impart excellent heat resistance, a favorable low modulus of elasticity, and/or a favorable low coefficient of thermal expansion to a cured product obtained by curing a curable resin composition. The phenolic hydroxyl group-containing structure and polyether structure will be described later.

The molecular structure of the compound of the present invention may be any of linear, partially branched linear, branched, cyclic, network, dendritic, or the like. One embodiment of the compound of the present invention is a linear co-modified silicone. Another embodiment of the compound of the present invention is a branched co-modified silicone.

The compound according to one embodiment of the present invention at room temperature may be liquid (oil-like) or raw rubber-like, but is preferably liquid. The viscosity of the compound according to one embodiment of the present invention at 25°C is, for example, in the range from 50 to 100000 mPa·s, preferably 100 to 10000 mPa·s, more preferably 1000 to 8000 mPa·s, and particularly preferably 2000 to 6000 mPa·s.
By adjusting the viscosity to the range above, compatibility with a resin and handling properties during work can be improved. Note that in the present specification, viscosity refers to a value measured at 25°C using an E-type viscometer.

The compound according to one embodiment of the present invention may also be a co-modified silicone expressed by the following average compositional formula (1).

R¹ₐR²_{b}R³_{c}R⁴_{d}SiO_{(4 - a - b - c - d)/2}

In the abovementioned average compositional formula (1), R¹ each independently represents a hydrogen atom or a monovalent hydrocarbon group with 1 to 18 carbon atoms, R² each independently represents a group having a phenolic hydroxyl group expressed by general formula (2) below, R³ each independently represents a group containing a polyether structure expressed by general formula (3) below, and R⁴ each independently represents a monovalent hydrocarbon group with 1 to 18 carbon atoms or a silicon-containing organic group; and
a, b, c, and d satisfy the relationships of b > 0, c > 0, a ≥ 0, d ≥ 0, and a + b + c + d = 4.

In average compositional formula (1) above, a preferably satisfies the relationship of 0 ≤ a < 4.00, more preferably 1.50 ≤ a ≤ 3.98, and even more preferably 3.00 ≤ a ≤ 3.95.
b preferably satisfies the relationship of 0 < b ≤ 0.90, more preferably 0.01 ≤ b ≤ 0.60, and even more preferably 0.02 ≤ b ≤ 0.30.
c preferably satisfies the relationship of 0 < c ≤ 0.90, more preferably 0.01 ≤ c ≤ 0.60, and even more preferably 0.02 ≤ c ≤ 0.30.
d preferably satisfies the relationship of 0 ≤ d ≤ 1.50, more preferably 0 ≤ d ≤ 1.00, and even more preferably 0 ≤ d ≤ 0.50.
Note that as described above, a, b, c, and d are within the numerical ranges above while satisfying a + b + c + d = 4.

In the abovementioned average compositional formula (1), the monovalent hydrocarbon group with 1 to 18 carbon atoms that can be selected as R¹ may be linear, branched, cyclic, saturated, or unsaturated, and includes alkyl groups, cycloalkyl groups, alkenyl groups, aryl groups, aralkyl groups, and halogenated alkyl groups. R¹ may be the same or may be different.
Specific examples of the alkyl group include methyl groups, ethyl groups, n-propyl groups, isopropyl groups, and other propyl groups, n-butyl groups, isobutyl groups, s-butyl groups, t-butyl groups, and other butyl groups, pentyl groups, hexyl groups, heptyl groups, octyl groups, nonyl groups, decyl groups, undecyl groups, dodecyl groups, hexadecyl groups, and octadecyl groups. Note that these groups also include structural isomers.
The cycloalkyl group is a monocyclic or polycyclic group, and includes cyclopentyl groups, and cyclohexyl groups.
Specific examples of the alkenyl group includes vinyl, allyl groups, 3-butenyl groups, and 5-hexenyl groups.
The aryl group is a monocyclic or polycyclic group, and specific examples include phenyl groups, tolyl groups, xylyl groups, and naphthyl groups.
The aralkyl group is an alkyl group substituted with an aryl group, and specific examples include benzyl groups, phenethyl groups, 3-phenylpropyl groups, and 4-phenylbutyl groups.
The halogenated alkyl group may be a group in which some or all of hydrogen atoms bonded to carbon atoms in the alkyl group have been substituted with chlorine atoms, fluorine atoms, bromine atoms, or other halogen atoms, and specific examples include chloromethyl groups, bromoethyl groups, 3-chloropropyl groups, 3,3,3-trifluoropropyl groups, chlorophenyl groups, and bromophenyl groups.
Of these, the monovalent hydrocarbon group is preferably an alkyl group with 1 to 6 carbon atoms or an aryl group with 6 to 12 carbon atoms, more preferably an alkyl group with 1 to 4 carbon atoms or an aryl group with 6 to 12 carbon atoms, and even more preferably a methyl group or a phenyl group.

In the abovementioned average compositional formula (1), R² represents a group having a phenolic hydroxyl group expressed by the following general formula (2).

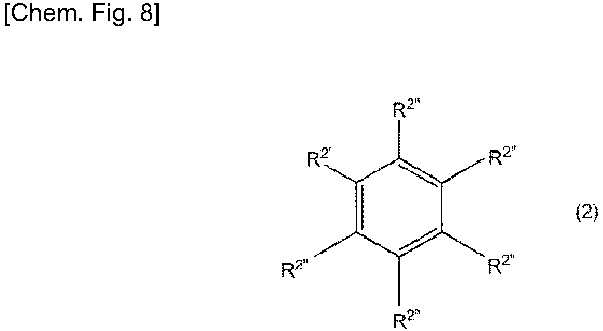

In the general formula (2) above,
R^{2'} represents a divalent hydrocarbon group with 1 to 18 carbon atoms bonded to a silicon atom, may be linear, branched, cyclic, saturated, or unsaturated, and includes alkylene groups, cycloalkylene groups, arylene groups, aralkylene groups, and alkenylene groups.
R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group. R^{2"} may be the same or may be different.

Specific examples of alkylene groups with 1 to 18 carbon atoms that can be selected as R^{2'} include various propylene groups such as methylene groups, 1,1-ethylene groups, 1,2-ethylene groups, 1,3-propylene groups, 1,2-propylene groups, and 2,2-propylene groups, as well as butylene groups, pentylene groups, hexylene groups, heptylene groups, octylene groups, nonylene groups, decylene groups, undecylene groups, and dodecylene groups. Note that these groups also include structural isomers.
The alkylene group is preferably an alkylene group with 1 to 8 carbon atoms, more preferably an alkylene group with 1 to 6 carbon atoms, and even more preferably an alkylene group with 1 to 4 carbon atoms.
Specific examples of the cycloalkylene group include cyclopropylene groups, cyclobutylene groups, cyclopentylene groups, and cyclohexylene groups.
Specific examples of the arylene group include phenylene groups, trilene groups, xylylene groups, and naphthylene groups.
Specific examples of the aralkylene group include benzylene groups, phenylethylene groups, 3-phenylpropylene groups, and 4-phenylbutylene groups. Specific examples of the alkenylene group include vinylene groups, 1-methylvinylene groups, propenylene groups, butenylene groups, and pentenylene groups.

The monovalent hydrocarbon group with 1 to 6 carbon atoms that can be selected as R^{2"} may be, for example, an alkyl group or an alkenyl group. The alkyl group may be linear, branched, or cyclic, and specific examples of the alkyl group include methyl groups, ethyl groups, n-propyl groups, isopropyl groups, and other propyl groups, n-butyl groups, isobutyl groups, s-butyl groups, t-butyl groups, and other butyl groups, pentyl groups, and hexyl groups. Note that these groups also include structural isomers.
The alkyl group is preferably an alkyl group with 1 to 4 carbon atoms, more preferably a methyl group, ethyl group, n-propyl group, isopropyl group, n-butyl group, isobutyl group, s-butyl group, or t-butyl group, and even more preferably a methyl group, ethyl group, n-butyl group, or t-butyl group.
Specific examples of the alkenyl group include vinyl and allyl groups.

Specific examples of the alkoxy groups with 1 to 6 carbon atoms that can be selected as R^{2"} include methoxy groups, ethoxy groups, propoxy groups, butoxy groups, pentyloxy groups, and hexyloxy groups. Note that these groups also include structural isomers.
The alkoxy group is preferably a methoxy group or an ethoxy group.

In one embodiment of the present invention, a preferred combination of R^{2"} in general formula (2) above is a hydrogen atom, a hydroxyl group, and an alkoxy group with 1 to 6 carbon atoms (e.g., a methoxy group). Eugenol is a specific example of a compound that has this combination. In other words, one embodiment of the present invention may be a co-modified silicone in which eugenol is introduced into a side chain via a divalent hydrocarbon group with 1 to 18 carbon atoms (e.g., an alkylene group) bonded to a silicon atom.

In another embodiment of the present invention, a preferred combination of R^{2"} in general formula (2) above is a hydrogen atom and a hydroxyl group. Catechol and phenol are specific examples of compounds having this combination. In other words, one embodiment of the present invention may be a co-modified silicone in which catechol or phenol is introduced into a side chain via a divalent hydrocarbon group with 1 to 18 carbon atoms (e.g., an alkylene group) bonded to a silicon atom.

The co-modified silicone according to one embodiment of the present invention may be a co-modified silicone having one or more selected from the group consisting of eugenol, catechol, and phenol in a side chain via a divalent hydrocarbon group with 1 to 18 carbon atoms (e.g., an alkylene group) bonded to a silicon atom.

In the abovementioned average compositional formula (1), R³ represents a group containing a polyether structure expressed by the following general formula (3). R³ may be the same or may be different. 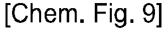 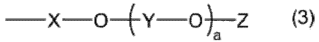 In general formula (3) above,
X represents a divalent hydrocarbon group with 1 to 18 carbon atoms,
Y represents an alkylene group with 1 to 6 carbon atoms,
a represents a number from 5 to 100, and
Z represents a hydrogen atom, a monovalent hydrocarbon group with 1 to 12 carbon atoms, or an acyl group with 1 to 12 carbon atoms.

X represents a divalent hydrocarbon group with 1 to 18 carbon atoms, may be linear, branched, cyclic, saturated, or unsaturated, and includes alkylene groups, cycloalkylene groups, arylene groups, aralkylene groups, and alkenylene groups. Specific examples of the alkylene group include various propylene groups such as methylene groups, 1,1-ethylene groups, 1,2-ethylene groups, 1,3-propylene groups, 1,2-propylene groups, and 2,2-propylene groups, as well as butylene groups, pentylene groups, hexylene groups, heptylene groups, octylene groups, nonylene groups, decylene groups, undecylene groups, and dodecylene groups. Note that these groups also include structural isomers.
The alkylene group is preferably an alkylene group with 1 to 8 carbon atoms, more preferably an alkylene group with 1 to 6 carbon atoms, and even more preferably an alkylene group with 1 to 4 carbon atoms.
Specific examples of the cycloalkylene group include cyclopropylene groups, cyclobutylene groups, cyclopentylene groups, and cyclohexylene groups. Specific examples of the arylene group include phenylene groups, trilene groups, xylylene groups, and naphthylene groups.
Specific examples of the aralkylene group include benzylene groups, phenylethylene groups, 3-phenylpropylene groups, and 4-phenylbutylene groups. Specific examples of the alkenylene group include vinylene groups, 1-methylvinylene groups, propenylene groups, butenylene groups, and pentenylene groups.

Specific examples of alkylene groups with 1 to 6 carbon atoms that can be selected as Y include various propylene groups such as methylene groups, 1,1-ethylene groups, 1,2-ethylene groups, 1,3-propylene groups, 1,2-propylene groups, and 2,2-propylene groups, as well as butylene groups, pentylene groups, and hexylene groups. Note that these groups also include structural isomers.
The alkylene group is preferably an alkylene group with 1 to 5 carbon atoms, more preferably an alkylene group with 2 to 5 carbon atoms, even more preferably an alkylene group with 2 to 4 carbon atoms, and particularly preferably one or more group selected from ethylene groups and propylene groups.
Furthermore, if a plurality of Ys are present, the plurality of Ys may each independently be an ethylene group, a propylene group, or a combination of ethylene groups and propylene groups (i.e., -Y-O- may be obtained by bonding an ethylene oxide (EO) group and a propylene oxide (PO) group randomly or in blocks).
Furthermore, -Y-O- contains an ethylene oxide (EO) group and a propylene oxide (PO) group, and preferably contains at least one ethylene group or a propylene group.

The value of a is preferably an integer from 5 to 80, more preferably an integer from 10 to 70, and even more preferably an integer from 15 to 60. Furthermore, in one embodiment, if -Y-O- contains an ethylene oxide (EO) group and a propylene oxide (PO) group, the number of EO groups (a1) in a is preferably 0 to 70, may be 1 to 70, more preferably 5 to 50, and even more preferably 10 to 30. Furthermore, the number of PO groups (a2) in a is preferably 0 to 70, may be 1 to 70, more preferably 5 to 50, and even more preferably 10 to 40.

Specific examples of the monovalent hydrocarbon groups with 1 to 12 carbon atoms that can be selected as Z include alkyl groups, aryl groups, aralkyl groups, phenethyl groups, and halogenated alkyl groups. These groups may be the same as those exemplified in average compositional formula (1) above as monovalent hydrocarbon groups with 1 to 12 carbon atoms that can be selected as R¹.

Specific examples of the acyl groups with 1 to 12 carbon atoms that can be selected as Z include formyl groups (methanoyl groups), acetyl groups (ethanoyl groups), propionyl groups (propanoyl groups), the benzoyl groups.

In one embodiment of the present invention, the group containing the polyether structure expressed by general formula (3) above may have a hydrophilic structure such as glycerol as part of a structure thereof. By introducing a glycerol group, the polyether can be branched, allowing a hydrophilic group to be locally positioned in a molecule. Furthermore, retaining the hydroxyl group of glycerol can further enhance the hydrophilicity thereof.

In the abovementioned average compositional formula (1), the monovalent hydrocarbon group with 1 to 18 carbon atoms that can be selected as R⁴ may be linear, branched, cyclic, saturated, or unsaturated, and includes alkyl groups, cycloalkyl groups, alkenyl groups, aryl groups, aralkyl groups, and halogenated alkyl groups. These groups may be the same as those exemplified in average compositional formula (1) above as monovalent hydrocarbon groups with 1 to 18 carbon atoms that can be selected as R¹.

In the compositional formula (1) above, the silicon-containing organic group that can be selected as R⁴ may be a silicon-containing organic group selected from silylalkyl groups having a carbosiloxidendron structure and groups having a siloxane macromonomer structure.
For example, R⁴ is one or more group selected from:
silylalkyl groups having a siloxandendron structure expressed by, when i is 1, the following general formula (4): 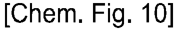 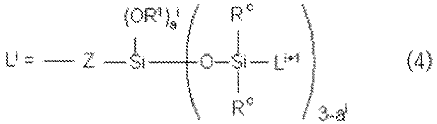
(where R¹ represents a substituted or unsubstituted monovalent hydrocarbon group with 1 to 6 carbon atoms or a hydrogen atom, R^{C} represents an alkyl group with 1 to 6 carbon atoms or a phenyl group, and Z represents a divalent organic group.
i represents the hierarchy of silylalkyl groups represented by Lⁱ, and is an integer from 1 to c when the number of repetitions of the silylalkyl groups is c; the hierarchy number of c is an integer from 1 to 10; and Lⁱ⁺¹ is the silylalkyl group when i is less than c, and is a methyl group or a phenyl group when i is c.
aⁱ is a number in the range from 0 to 3.);
chain organosiloxane groups expressed by the following general formula (4'): 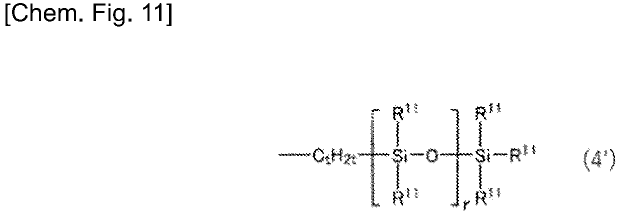
(where R¹¹ each independently represents a substituted or unsubstituted monovalent hydrocarbon group with 1 to 30 carbon atoms, a hydroxyl group, or a hydrogen atom, but at least one of the R¹¹ groups is a monovalent hydrocarbon group.
t is a number from 2 to 10, and r is a number from 1 to 500.); and
chain organosiloxanes expressed by the following general formula (4"): 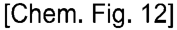 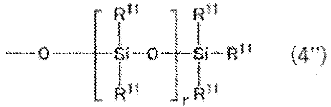 (where R¹¹ and r are as described above.).

The groups represented by R⁴ may be the same or different. For example, a silylalkyl group having a carbosiloxidendron structure and a group having a siloxane macromonomer structure may be present in the same molecule. The silylalkyl group may be a combination of silicon-containing organic groups with different degrees of branching (generations), and the group having a siloxane macromonomer structure may be a combination of silicon-containing organic groups with different degrees of polymerization.

The group represented by R⁴ may be a silylalkyl group having a carbosiloxane dendrimer structure and is defined as the silylalkyl group expressed by general formula (4) above when i is 1. The silylalkyl group having the carbosiloxane dendrimer structure is a functional group that has a structure in which the carbosiloxane unit is spread out in a dendrimer-like manner, and therefore exhibits high water repellency compared to linear or simply branched polysiloxane units.

In general formula (4), R^{C} represents an alkyl group with 1 to 6 carbon atoms or a phenyl group, but a methyl group or phenyl group is industrially preferable.

In general formula (4), i represents the hierarchy of silylalkyl groups represented by L¹, and is an integer from 1 to c when the number of repetitions of the silylalkyl groups is c; the hierarchy number of c is an integer from 1 to 10; and Lⁱ⁺¹ is the silylalkyl group when i is less than c, and is a methyl group or a phenyl group when i is c. In particular, it is preferably a methyl group when i is c.

Note that the hierarchy number c is preferably an integer from 1 to 3 and is more preferably 1 or 2 from an industrial standpoint. For each of hierarchy numbers, the group represented by Lⁱ is expressed as follows. In the formula, R¹, R^{c}, and Z are the same groups as described above.

When the hierarchy number c is 1, Lⁱ is given by the following general formula (4-1).

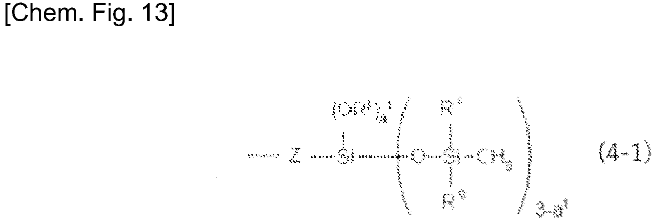

When the hierarchy number c is 2, Lⁱ is given by the following general formula (4-2).

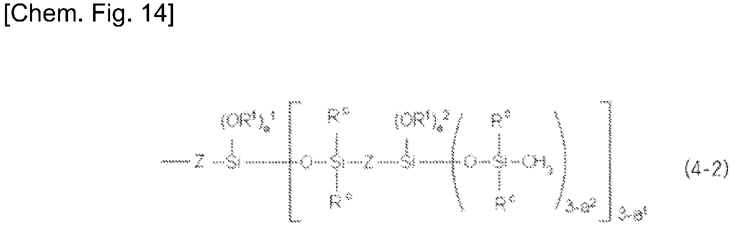

In general formula (4) above, aⁱ independently represents a number in the range from 0 to 3. In the structures expressed in formulas (4-1) to (4-2) in which the hierarchy number is 1 to 2, a¹ and a² each independently represent a number in the range from 0 to 3. These aⁱ moieties are preferably numbers within the range of from 0 to 1, and aⁱ is particularly preferably 0.

In general formula (4) above, Z each independently represent a divalent organic group, and specific examples thereof include divalent organic groups formed by addition-reacting a silicon-bonded hydrogen atom with a functional group having an unsaturated hydrocarbon group such as an alkenyl group, an acryloxy group, or a methacryloxy group, at an end. Depending on the method for introducing the silylalkyl group having a carbosiloxane dendrimer structure, the functional group can be appropriately selected and is not limited to the functional groups described above. Z in the present invention preferably represents an alkylene group with 2 to 10 carbon atoms, more preferably an alkylene group with 2 to 6 carbon atoms, and most preferably an ethylene group.

The group represented by R⁴ may be a siloxane macromonomer structure-containing group that is bonded to a silicon atom constituting a main chain via an oxygen atom or an alkylene group, and is a hydrophobic functional group that exhibits a certain degree of water repellency or lipophilicity. Specifically, the group represented by R⁴ may be a functional group expressed by general formula (4´) and general formula (4") above. In the formulas, R¹¹ particularly industrially preferably represents a methyl group, phenyl group or hydroxyl group, and at least a portion of R¹¹ is a methyl group, and a portion is preferably in the form of a long chain alkyl group with 8 to 30 carbon atoms. However, at least one R¹¹ represents a monovalent hydrocarbon group such as a methyl group or the like, t is a number in the range from 2 to 10, and r is a number in the range from 1 to 500. From the perspective of compatibility with various oil agents, r is preferably a number in the range from 1 to 100, and r is particularly preferably a number in the range from 2 to 30.

The compound according to one embodiment of the present invention may be a co-modified silicone expressed by average compositional formula (2).

(R¹₂R'SiO_{1/2})ₐ(R²R'SiO_{2/2})_{b}(R³R'SiO_{2/2})_{b'}(R⁴R'SiO_{2/2})_{b"}(R'SiO_{3/2})_{c}(SiO_{4/2})_{d}

In the abovementioned average compositional formula (2), R¹ each independently represents a hydrogen atom or a monovalent hydrocarbon group with 1 to 18 carbon atoms, R² each independently represents a group having a phenolic hydroxyl group expressed by general formula (2) above, R³ each independently represents a group containing a polyether structure expressed by general formula (3) above, R⁴ each independently represents a monovalent hydrocarbon group with 1 to 18 carbon atoms or a silicon-containing organic group, and R' each independently represents any one of R¹, R², R³, or R⁴; and a, b, b', b", c, and d satisfy the relationships of b > 0, b' > 0, a ≥ 0, b" ≥ 0, c ≥ 0, d ≥ 0, and 20 ≤ a + b + b' + b" + c + d ≤ 1000.

In average compositional formula (2) above, a preferably satisfies the relationship of 2 ≤ a ≤ 15, more preferably 2 ≤ a ≤ 10, and even more preferably 2 ≤ a ≤ 8.
b preferably satisfies the relationship of 0 < b ≤ 100, more preferably 1 ≤ b ≤ 50, and even more preferably 1 ≤ b ≤ 20.
b' preferably satisfies the relationship of 0 < b' ≤ 100, more preferably 1 ≤ b' ≤ 50, and even more preferably 1 ≤ b' ≤ 20.
b" preferably satisfies the relationship of 0 ≤ b" ≤ 1000, more preferably 5 ≤ b" ≤ 500, and even more preferably 10 ≤ b" ≤ 300.
c preferably satisfies the relationship of 0 ≤ c ≤ 15, more preferably 0 ≤ c ≤ 10, and even more preferably 0 ≤ c ≤ 5. Furthermore, as c increases, the co-modified silicone gels or solidifies even at room temperature. Therefore, c is preferably within a range in which the compound of the present invention remains liquid (as defined by the Fire Service Act).
d preferably satisfies the relationship of 0 ≤ d ≤ 15, more preferably 0 ≤ d ≤ 10, and even more preferably 0 ≤ d ≤ 5. Furthermore, as d increases, the co-modified silicone gels or solidifies even at room temperature. Therefore, c is preferably within a range in which the compound of the present invention remains liquid (as defined by the Fire Service Act).
a + b + b' + b" + c + d preferably satisfies the relationship of 20 ≤ d ≤ 1000, more preferably 30 ≤ d ≤ 600, and even more preferably 40 ≤ d ≤ 350.
Note that as described above, a, b, b', b", c, and d satisfy the numerical ranges above.

In average compositional formula (2) above, the monovalent hydrocarbon group with 1 to 18 carbon atoms that can be selected as R¹ may be the same as R¹ in average compositional formula (1) above. R¹ may be the same or may be different.

In average compositional formula (2) above, the group having a phenolic hydroxyl group that can be selected as R² may be the same as R² in average compositional formula (1) above. R² may be the same or may be different.

In average compositional formula (2) above, the group containing a polyether structure that can be selected as R³ may be the same as R³ in average compositional formula (1) above. R3 may be the same or may be different.

In average compositional formula (2) above, the monovalent hydrocarbon group with 1 to 18 carbon atoms or the silicon-containing organic group that can be selected as R⁴ may be the same as R⁴ in average compositional formula (1) above. R⁴ may be the same or may be different.

In average compositional formula (2) above, R' independently represents any one of R¹, R², R³, or R⁴, and R¹, R², R³, or R⁴ are as described above.

The compound according to one embodiment of the present invention may be a co-modified silicone having a structure expressed by the following general formula (1).

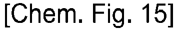

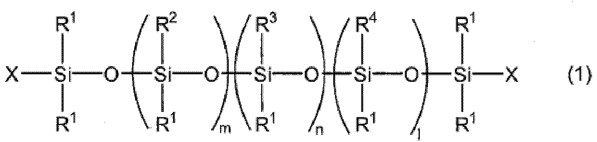

In general formula (1) above,
R¹ each independently represents a hydrogen atom or a monovalent hydrocarbon group with 1 to 18 carbon atoms,
R² each independently represents a group having a phenolic hydroxyl group expressed by general formula (2) above,
R³ each independently represents a group containing a polyether structure expressed by general formula (3) above,
R⁴ each independently represents a monovalent hydrocarbon group or silicon-containing organic group with 1 to 18 carbon atoms,
X each independently represents any one of R¹, R², R³, or R⁴,
m represents a number from 0 to 100, where if m is 0, at least one X is R²,
n represents a number from 0 to 100, where if n is 0, at least one X is R³,
when m = n = 0 is satisfied, two Xs in a molecule are R² and R³, respectively, and l represents a number from 0 to 1000.

In general formula (1) above, the monovalent hydrocarbon group with 1 to 18 carbon atoms that can be selected as R¹ may be the same as R¹ in average compositional formula (1) above. R¹ may be the same or may be different.

In general formula (1) above, the group having a phenolic hydroxyl group that can be selected as R² may be the same as R² in average compositional formula (1) above. R² may be the same or may be different.

In general formula (1) above, the group containing a polyether structure that can be selected as R³ may be the same as R³ in average compositional formula (1) above. R³ may be the same or may be different.

In general formula (1) above, the monovalent hydrocarbon group with 1 to 18 carbon atoms or the silicon-containing organic group that can be selected as R⁴ may be the same as R⁴ in average compositional formula (1) above. R⁴ may be the same or may be different.

In general formula (1) above, X independently represents any one of R¹, R², R³, or R⁴, and R¹, R², R³, or R⁴ are as described above.

In general formula (1) above, m is preferably 1 to 100, more preferably 1 to 50, and even more preferably 1 to 20.
n is preferably 1 to 100, more preferably 1 to 50, and even more preferably 1 to 20. Note that when m = n = 0 is satisfied, the two X values in the molecule are R² and R³, respectively, and R² and R³ are as described above.
l is preferably 0 to 1000, more preferably 5 to 500, and even more preferably 10 to 300.
Furthermore, m + n + l is preferably 20 to 1000, more preferably 30 to 600, and even more preferably 40 to 350.

Herein, in the present specification, the structures and the like of the organic groups (i.e., R¹, R², R³, and R⁴ in average compositional formula (1), average compositional formula (2), and general formula (1)) in the co-modified silicone can be analyzed using ¹³C-NMR. Furthermore, the structure and degree of polymerization of the siloxane units (i.e., M units, D units, T units, and Q units) in the co-modified silicone can be analyzed using ²⁹Si-NMR. By using these in combination, it is possible to identify the specific chemical structures of the phenolic hydroxyl group-containing structure, the polyether structure, and the siloxane main chain of the compound of the present invention. If necessary, gas chromatography, liquid chromatography, or the like may be used. Furthermore, for the purpose of controlling or improving the performance and quality of the ultimately obtained co-modified silicone as a resin additive, the amount of unreacted raw materials such as unreacted polyether raw materials, other than the co-modified silicone, may be quantified.

### 1.1 Method for Manufacturing Co-Modified Silicone

In one aspect, the present invention provides a method for manufacturing a co-modified silicone (hereinafter also referred to as "the manufacturing method of the present invention"). The manufacturing method of the present invention is not particularly limited so long as the method can introduce the phenolic hydroxyl group-containing structure and the polyether structure of the compound of the present invention. An example of one method involves an addition reaction (e.g., hydrosilylation reaction) between an organopolysiloxane having a hydrogen atom (Si-H) bonded to a silicon atom, a phenolic hydroxyl group-containing precursor compound having a carbon-carbon double bond, and a polyether structure-containing precursor compound having a carbon-carbon double bond. The phenolic hydroxyl group-containing precursor compound includes compounds having a structure expressed by general formula (2) as described in "1. Co-Modified Silicone" above, and specific examples include 2-allylphenol and eugenol.

The polyether structure-containing precursor compound includes compounds having a structure expressed by general formula (3) as described in "1. Co-Modified Silicone" above, and specific examples include polyethylene glycol, polypropylene glycol, and ethylene glycol-propylene glycol copolymer.

In one embodiment of the present invention, in addition to the phenolic hydroxyl group-containing precursor compound having a carbon-carbon double bond and the polyether structure-containing precursor compound having a carbon-carbon double bond, a precursor compound having the R⁴ group (a monovalent hydrocarbon group with 1 to 18 carbon atoms or a silicon-containing organic group) in average compositional formula (1), average compositional formula (2), and general formula (1) described above in "1. Co-Modified Silicone" may be further addition-reacted with the organopolysiloxane to introduce the group represented by R⁴ into the compound according to one embodiment of the present invention.

The order in which the abovementioned precursor compounds are added to the organopolysiloxane is not particularly limited. For example, each precursor compound may be added simultaneously, or may be added separately.

The reaction temperature between the organopolysiloxane and each precursor compound is not particularly limited so long as the desired reaction proceeds. In one embodiment, the addition reaction may be performed under heating. When performing an addition reaction under heating, the reaction temperature is preferably in the range from 30°C to 150°C.

Furthermore, the addition reaction above can be performed at an arbitrary pressure, and the pressure is not particularly limited. However, depending on the boiling point of the raw materials used, if the desired temperature cannot be reached when heated at ambient pressure, or if the time required to complete the reaction at ambient pressure is significantly longer, the reaction may be performed under pressure. In order to shorten or eliminate subsequent stripping process for removing solvent and an unreacted raw material, the reaction can also be performed under reduced pressure, provided that the solvent and raw material are not removed from the system.

The addition reaction above is preferably performed under an inert gas atmosphere, for example, an inert gas selected from nitrogen, argon, and the like. Furthermore, the amount of water in the organopolysiloxane having silicon atom-bonded hydrogen atoms, which is a raw material, and in the precursor compound is preferably minimized.

Furthermore, in addition to being solvent-free, the addition reaction described above may use, as a reaction solvent, an organic solvent selected from toluene, xylene, benzene, hexane, heptane, methylcyclohexane, ethylene chloride, chloroform, trichloroethylene, cyclohexane, ethyl acetate, methyl ethyl ketone, isopropyl alcohol, and the like, if necessary.

Examples of suitable catalysts for when a hydrosilylation reaction is performed between an organopolysiloxane having a silicon atom-bonded hydrogen atom and a precursor compound include platinum-based catalysts, palladium-based catalysts, rhodium catalysts, and other catalysts belonging to the Group VIII transition metal system in the long-period periodic table, with platinum-based catalysts being preferred. Examples of such platinum-based catalysts include carbon powder supported with a platinum metal, platinum black, platinum chloride, chloroplatinic acid, reaction products of chloroplatinic acid and monohydric alcohols, alcohol solutions of chloroplatinic acid, platinum olefin complexes, platinum alkenylsiloxane complexes, platinum carbonyl complexes, and platinum(II) acetylacetonate. The amount of catalyst used is not particularly limited so long as the desired reaction proceeds.

A step for removing low-boiling-point compounds such as a solvent, low-boiling substances derived from raw materials, and unreacted raw materials is preferably performed after the addition reaction described above. This prevents problems such as voids that can occur during epoxy resin molding due to the presence of low-boiling point substances, and contact failure in electronic devices.

Furthermore, filtration can be performed before or after the low-boiling-point substance removal step. In addition to removing precipitated solid materials, ionic impurities such as halogens and metals can also be removed by filtration using a filter or adsorbent that has an adsorption effect. Before and after filtration, the synthesized co-modified silicone may be washed with a poor solvent, such as methanol, in order to reduce or remove an unreacted raw material such as an unreacted polyether raw material, thereby achieving higher purity. Moreover, in the manufacturing stage of the co-modified silicone of the present invention, a treatment using an organic wax as an adsorbent (e.g., PEG #20000 (polyethylene oxide having a molecular weight of 20000; a melting point: approximately 65°C), and the like), as described in WO 2014/104257, may be performed to remove or reduce impurities and thereby achieve higher purity.

### 2. Additive for Organic Resin

As one aspect of the present invention, the present invention provides an additive for an organic resin (hereinafter also referred to as "the additive of the present invention"), the additive containing the co-modified silicone described in "1. Co-Modified Silicone" above.

The co-modified silicone included in the additive of the present invention is subject to the matters described in "1. Co-Modified Silicone" above. The co-modified silicone according to the present invention has excellent heat resistance and curability, improves close adhesion and interaction between a curable resin and a filler (preferably an inorganic filler), and possesses flexibility derived from a silicone skeleton. Therefore, when added to a curable resin composition, the co-modified silicone according to the present invention has the advantage of reducing the coefficient of linear expansion (CTE) of an ultimately obtained cured product without impairing the curing reactivity thereof, thereby providing a cured product that is flexible and has excellent close adhesion.

The amount of the co-modified silicone in the additive according to one embodiment of the present invention is not particularly limited, but may be 30 to 100 mass%, 40 to 100 mass%, or 50 to 100 mass%, relative to the total amount (100 mass%) of the additive.
In some embodiments, the additive of the present invention may substantially contain the compound according to one embodiment of the present invention. In the present specification, "substantially contain the compound according to one embodiment of the present invention" means that other components, such as impurities, may be included, which are inevitably present in the manufacturing process of the co-modified silicone and are difficult or unnecessary to separate from each other. In this embodiment, the additive of the present invention may contain, for example, the other components in an amount of 30 mass% or less, 15 mass% or less, 10 mass% or less, 5 mass% or less, 4 mass% or less, 3 mass% or less, 2 mass% or less, 1.0 mass% or less, or 0.5 mass% or less, relative to the total amount of the additive (100 mass%). For example, unreacted polyether raw materials remaining in the system after the manufacturing of the co-modified silicone may be included in the additive of the present invention without being separated.

With regard to the additive according to one embodiment of the present invention, examples of the organic resin include thermosetting resins and thermoplastic resins, but epoxy resins may also be included, for example. In other words, the additive according to one embodiment of the present invention may be an additive for an epoxy resin. The epoxy resin will be described later.

### 3. Curable Resin Composition

As one aspect of the present invention, the present invention provides a curable resin composition (hereinafter also referred to as "the composition of the present invention"), the additive containing the co-modified silicone described in "1. Co-Modified Silicone" above.

The composition according to one aspect of the present invention contains an epoxy resin (A), a curing agent (B), a filler (C), and a compound (D) according to one embodiment of the present invention.

Each component constituting the composition of the present invention will be described in detail below. Note that the matters described in "1. Co-Modified Silicone" above apply to the compound (D) according to one embodiment of the present invention.

### 3.1 Epoxy Resin (A)

The composition according to one embodiment of the present invention contains the epoxy resin (A). The epoxy resin (A) is a curable resin having an epoxy group, and specific examples include bixylenol-type epoxy resins, bisphenol A-type epoxy resins, bisphenol F-type epoxy resins, bisphenol S-type epoxy resins, bisphenol AF-type epoxy resins, dicyclopentadiene-type epoxy resins, trisphenol-type epoxy resins, naphthol novolac-type epoxy resins, phenol novolac-type epoxy resins, tert-butyl-catechol-type epoxy resins, naphthalene-type epoxy resins, naphthol-type epoxy resins, anthracene-type epoxy resins, glycidylamine-type epoxy resins, glycidyl ester-type epoxy resins, cresol novolac-type epoxy resins, phenol aralkyl-type epoxy resins, biphenyl-type epoxy resins, linear aliphatic epoxy resins, epoxy resins having a butadiene structure, alicyclic epoxy resins, heterocyclic epoxy resins, spiroring-containing epoxy resins, cyclohexane-type epoxy resins, cyclohexanedimethanol-type epoxy resins, naphthylene ether-type epoxy resins, trimethylol-type epoxy resins, tetraphenylethane-type epoxy resins, isocyanurate-type epoxy resins, and phenolphthaleimidine-type epoxy resins. The epoxy resin may be used alone or in combination of two or more types.

Furthermore, from the perspective of obtaining a cured product with excellent heat resistance, the epoxy resin (A) preferably includes an epoxy resin containing an aromatic structure. An aromatic structure is a chemical structure generally defined as aromatic, and includes polycyclic aromatics and aromatic heterocyclics.
Specific examples of epoxy resins containing an aromatic structure include bisphenol A-type epoxy resins, bisphenol F-type epoxy resins, bisphenol S-type epoxy resins, bisphenol AF-type epoxy resins, dicyclopentadiene-type epoxy resins, trisphenol-type epoxy resins, naphthol novolac-type epoxy resins, phenol novolac-type epoxy resins, tert-butyl-catechol-type epoxy resins, naphthalene-type epoxy resins, naphthol-type epoxy resins, anthracene-type epoxy resins, bixylenol-type epoxy resins, glycidylamine-type epoxy resins having an aromatic structure, glycidyl ester-type epoxy resins having an aromatic structure, cresol novolac-type epoxy resins, biphenyl-type epoxy resins, linear aliphatic epoxy resins having an aromatic structure, epoxy resins having a butadiene structure that has an aromatic structure, alicyclic epoxy resins having an aromatic structure, heterocyclic epoxy resins, spiroring-containing epoxy resins having an aromatic structure, cyclohexanedimethanol-type epoxy resins having an aromatic structure, naphthylene ether-type epoxy resins, trimethylol-type epoxy resins having an aromatic structure, and tetraphenylethane-type epoxy resins having an aromatic structure.

The amount of the epoxy resin (A) is, for example, 1 mass% or more, and preferably 2 mass% or more, relative to 100 mass% of the total solid fraction of the composition. This allows for appropriate setting of the fluidity of the composition during molding, thereby improving filling properties.
Furthermore, the amount of the epoxy resin (A) is, for example, 15 mass% or less, preferably 10 mass% or less, and more preferably 5 mass% or less, relative to 100 mass% of the total solid fraction of the composition. Typically, the coefficient of thermal expansion of the resin is greater than that of the filler (C) (described later). Therefore, it is considered that thermal shrinkage can be further reduced by using a relatively small amount of the epoxy resin (A). In other words, it is thought that warping of a base material can be further reduced.
Note that the total solid fraction of the composition refers to the sum of all components in the composition according to one embodiment of the present invention, excluding the solvent.

### 3.2 Curing Agent (B)

The composition according to one embodiment of the present invention contains the curing agent (B). The curing agent (B) is not particularly limited so long as the epoxy resin can be cured.

The curing agent (B) preferably includes a phenolic curing agent. Phenolic curing agents are preferred from the perspective of balance between flame resistance, moisture resistance, electrical properties, curability, storage stability, and the like. Phenolic curing agents include monomers, oligomers, and polymers, that have two or more phenolic hydroxyl groups in a molecule. Note that the molecular weight, molecular structure, and the like are not particularly limited. More specifically, phenolic curing agents include novolac-type phenolic resins such as phenol novolac resins, cresol novolac resins, bisphenol novolac, and phenol-biphenyl novolac resins; polyvinylphenols; polyfunctional phenolic resins such as trisphenylmethane-type phenolic resins; modified phenolic resins such as terpene-modified phenolic resins and dicyclopentadienemodified phenolic resins; phenolic aralkyl-type phenolic resins such as phenolic aralkyl resins having a phenylene skeleton and/or biphenylene skeleton, and naphthol aralkyl resins having a phenylene and/or biphenylene skeleton; and bisphenol compounds such as bisphenol A and bisphenol F.

Examples of other curing agents (B) besides phenolic curing agents include amine-based curing agents, acid anhydride-based curing agents, mercaptan-based curing agents, and catalytic curing agents.
Specific examples of amine-based curing agents include aliphatic polyamines and aromatic polyamines.
Specific examples of acid anhydride-based curing agents include alicyclic acid anhydrides such as hexahydrophthalic anhydride (HHPA) and methyltetrahydrophthalic anhydride (MTHPA), and aromatic acid anhydrides such as trimellitic anhydride (TMA), pyromellitic anhydride (PMDA), and benzophenonetetracarboxylic acid (BTDA).
Mercaptan-based curing agents include polymercaptan compounds such as polysulfides, thioesters, and thioethers.
Specific examples of catalytic curing agents include: tertiary amine compounds such as benzyldimethylamine (BDMA) and 2,4,6-trisdimethylaminomethylphenol; imidazole compounds such as 2-methylimidazole and 2-ethyl-4-methylimidazole; and Lewis acids such as BF₃ complexes.
Note that the curing agent (B) may be used alone or in combination of two or more types.

The amount of the curing agent (B) is, for example, 0.5 mass% or more, preferably 1 mass% or more, and more preferably 1.5 mass% or more, relative to 100 mass% of the total solid fraction of the composition. This results in excellent fluidity during molding, improving filling properties and moldability.
Furthermore, the amount of the curing agent (B) is, for example, 9 mass% or less, preferably 8 mass% or less, and more preferably 7 mass% or less, relative to 100 mass% of the total solid fraction of the composition. This can contribute to further suppressing warping of a base material.

### 3.3 Filler (C)

The composition according to one embodiment of the present invention contains the filler (C). The filler (C) may be an inorganic filler or an organic filler. Specific examples of inorganic fillers include silica, alumina, silicon nitride, aluminum nitride, boron nitride, titanium oxide, silicon carbide, titanium white, aluminum hydroxide, magnesium hydroxide, talc, clay, mica, glass fiber, diamond, graphite, carbon nanotubes, and allotropes of carbon such as graphene. Specific examples of the organic filler include rubber powders such as styrene-type, butadiene-type, and acrylic-type; silicone resin powders; silicone elastomer particles; silicone elastomer composite particles; silicone resin-coated silicone elastomer particles; acrylic core-shell particles; and other resins. The filler (C) may be used alone or in combination of two or more types. Furthermore, the filler (C) may be a combination of inorganic and organic fillers. By replacing a portion of the inorganic filler with an organic filler, the coefficient of linear expansion (CTE) and elastic modulus can be reduced while maintaining the strength of the cured product.
The particle shape can be spherical, plate-like, granular, fibrous, or woven, but is preferably as spherical as possible. Furthermore, the filling volume can be increased by mixing particles of different sizes. Furthermore, if the filler (C) is an inorganic filler, from the perspective of heat dissipation, silica can be partially or completely replaced with alumina, silicon nitride, aluminum nitride, boron nitride, or the like.

Of these, the filler (C) preferably contains an inorganic filler, and more preferably contains silica. Examples of silica include molten crushed silica, molten spherical silica, crystalline silica, and secondary aggregated silica.
As described above, the filler (C) is usually in the form of particles, and the shape of the particles may be perfectly spherical, but is not limited thereto.
The average particle size of the filler (C) is not particularly limited, but is typically 0.1 to 100 µm, preferably 0.5 to 50 µm, and more preferably 1 to 20 µm. By having the average particle size within the range above, appropriate fluidity during curing can be ensured. Note that by making the average particle size relatively small (e.g., 1 to 20 µm) and combining particles with different average particle sizes, filling properties into narrow gap portions can be improved in state-of-the-art wafer-level packages, for example.
The average particle size of the filler (C) can be determined by acquiring volume-based particle size distribution data using a laser diffraction/scattering particle size distribution measuring device and processing the data. Measurements are usually performed using a wet method.

If the filler (C) is an inorganic filler such as silica, the filler may be surfacemodified with a coupling agent such as a silane coupling agent or a titaniumbased coupling agent. This suppresses the aggregation of inorganic fillers, resulting in more favorable fluidity. Furthermore, the affinity between the inorganic filler and other components increases, and the dispersibility of the inorganic filler improves. This is considered to contribute to improving the mechanical strength of a cured product and suppressing the occurrence of microcracks.
Note that the coupling agent used for surface modification will be described later in the section on the coupling agent (E).

The amount of the filler (C) is, for example, 45 mass% or more, 55 mass% or more, preferably 70 mass% or more, and more preferably 85 mass% or more, relative to 100 mass% of the total solid fraction of the composition. By moderately increasing the amount of the filler (C), the warping of a substrate can be further reduced. Furthermore, by moderately increasing the amount of the filler (C) and relatively reducing the amount of the resin component, change in thermal expansion after the composition has become a cured product can be reduced. Increased warping is easier to suppress when the change in thermal expansion is small.
Furthermore, the amount of the filler (C) is, for example, 98 mass% or less, preferably 95 mass% or less, and more preferably 92 mass% or less, relative to 100 mass% of the total solid fraction of the composition. By moderately reducing the amount of the filler (C), the decrease in moldability that occurs due to a decrease in fluidity during molding can be suppressed.

### 3.4 Compound (D) According to One Embodiment of Present Invention

The composition according to one embodiment of the present invention contains the compound (D) according to one embodiment of the present invention. The structure and the like of the compound (D) according to one embodiment of the present invention as described in "1. Co-Modified Silicone" above.

The amount of the compound (D) according to one embodiment of the present invention is, for example, 0.1 mass% or more, preferably 0.5 mass% or more, and more preferably 1 mass% or more, relative to 100 mass% of the total solid fraction of the composition. This makes it possible to impart excellent heat resistance, a favorable low modulus of elasticity, and/or a favorable low coefficient of thermal expansion to a cured product of the composition.
Furthermore, the amount of the compound (D) according to one embodiment of the present invention is, for example, 20 mass% or less, preferably 15 mass% or less, and more preferably 10 mass% or less, relative to 100 mass% of the total solid fraction of the composition, and is generally used in the range from 0.1 to 10 mass%, relative to 100 mass% of the total solid fraction of the composition. This allows for maintaining an appropriate modulus of elasticity without excessively reducing strength.

### 3.5 Coupling Agent (E)

The composition according to one embodiment of the present invention may optionally contain a coupling agent. By including a coupling agent (E), close adhesion to a base material can be further improved and the dispersibility of the filler (C) in the composition can be improved, for example. Improved dispersibility of the filler (C) can lead to improved homogeneity of an ultimately obtained cured product, potentially contributing to increased mechanical strength and the like.

Examples of known coupling agents (E) include epoxysilanes, mercaptosilanes, aminosilanes, alkylsilanes, ureidosilanes, alkenylsilanes such as vinylsilanes and hexenylsilanes, various silane compounds such as acrylicsilanes and methacrylicsilanes, titanium compounds, aluminum chelates, and aluminum/zirconium compounds. The coupling agent (E) may be used alone or in combination of two or more types. Furthermore, a known surface treatment agent such as silazane may be used in combination therewith.

The amount of the coupling agent (E) is, for example, 0.1 mass% or more, and preferably 0.2 mass% or more, relative to the total composition. Note that the coupling agent (E) is generally used in an amount in the range from 0.01% to 2 mass%, assuming that the total mass of the filler (C) is 100 mass%. Furthermore, the amount of the coupling agent (E) is, for example, 2.0 mass% or less, and preferably 1.0 mass% or less, relative to the total composition.

### 3.6 Other Components

The composition according to one embodiment of the present invention may optionally contain another optional component. Examples of such optional components include various additives such as pH adjusters, ion scavengers, flame retardants, coloring agents, mold release agents, low-stress agents (excluding those corresponding to the compound (D) according to one embodiment of the present invention), antioxidants, and heavy metal deactivators. Specific examples of substances that can be used include those listed in Patent Document 2 (see paragraphs [0070] to [0075]), WO 2024/202136 (paragraphs [0083] to [0086]), and WO 2021/149727 (paragraphs [0090] to [0093]).

When these optional components are included, the amount of each component varies depending on the type and use thereof, but should be within a range that does not impair the effects of the present invention, for example, in the range from 0.1 to 15.0 mass%, preferably 0.1 to 10.0 mass%, and more preferably 0.2 to 5.0 mass%.

### 3.7 Method for Manufacturing Composition of Present Invention, Method for Forming Cured Product, and Applications

The composition according to one embodiment of the present invention can be obtained by uniformly mixing components (A) to (D) and another optional component such as component (E). Mixing can be performed using an appropriate device such as a mixer or blender. The mixture obtained therefrom can be melt-kneaded using a kneader, heating roller, or the like, preferably at a temperature from 40°C to 130°C, and then cooled and solidified to prepare the composition according to one embodiment of the present invention (specifically, a liquid, solid, or heat-meltable (hot-melt, also known as B-stage) curable epoxy resin composition). The composition may be crushed into a powder or granules. Alternatively, the powder/granular composition may be compressed into tablets. Furthermore, the mixture of the composition above can be received on a pallet, cooled, and then formed into a sheet by a method such as press rolling, roller rolling, or coating after mixing with a solvent, thereby manufacturing a sheet-like composition

The composition according to one embodiment of the present invention can be optionally melted by heating or the like, and then cured using a known curing method depending on the type of the curable resin, to obtain a cured product of the composition according to one embodiment of the present invention. For example, if the composition according to one embodiment of the present invention contains an epoxy resin, the composition may optionally be melted by heating and then finally cured by heating. In this case, the curing reaction temperature is, for example, in the range from 100 to 300°C, preferably 150 to 250°C, more preferably 150 to 200°C, and even more preferably 170 to 180°C.

The cured product according to one embodiment of the present invention has properties such as heat resistance, low modulus of elasticity, and/or low coefficient of thermal expansion, and can therefore be suitably used in a semiconductor device. More specifically, the cured product can be suitably used as, for example, a sealing material for a semiconductor element or IC chip, a pressure-sensitive adhesive, an underfilling agent, an insulating material, or build-up material for a package substrate of a semiconductor device.

### 4. Semiconductor Device and Method for Manufacturing Semiconductor Device

As one aspect, the present invention provides a semiconductor device (hereinafter also referred to as "the semiconductor device of the present invention ") including the cured product as described in "3.7 Method for Manufacturing Composition of Present Invention, Method for Forming Cured Product, and Applications" above.

Specific examples of the semiconductor device described above include those described in "3.7 Method for Manufacturing Composition of Present Invention, Method for Forming Cured Product, and Applications" above.

Furthermore, as one aspect, the present invention provides a method for manufacturing a semiconductor device (hereinafter also referred to as "the method for manufacturing a semiconductor device of the present invention"), which involves curing the composition according to one embodiment of the present invention.

Furthermore, as described above, the curable resin composition of the present invention, and particularly the curable epoxy resin composition (in powder, tablet, granular, or the like), can be suitably used as a heat-meltable (B-stage material) sealing material for sealing a semiconductor element. The method for sealing a semiconductor element is not particularly limited and can be performed by a known method such as conventional transfer molding or compression molding. The semiconductor package to which the cured product of the present invention can be applied is not particularly limited, and can be used for sealing various semiconductor packages as described in, for example, JP 2020-063338 A, JP 2019-085514 A, and JP 2020-023643 A.

The method for manufacturing a semiconductor device of the present invention is not particularly limited, and may include a step for curing the composition of the present invention at any stage of the semiconductor device manufacturing process. Furthermore, the method for manufacturing a semiconductor device of the present invention may include a step for sealing a semiconductor element with the cured product according to one embodiment of the present invention.

For example, a semiconductor device can be manufactured in which semiconductor elements are sealed with the cured product according to one embodiment of the present invention by placing a laminate body on which a plurality of semiconductor elements are provided, such as ICs, into a cavity of a metal die, filling the cavity with the composition according to one embodiment of the present invention, and then heating and curing the composition.

Note that the molding conditions can be appropriately selected depending on the molding method, the curability of the curable resin composition, the metal die temperature, and the like. As an example, the conditions for transfer molding using the curable epoxy resin composition of the present invention can be appropriately set depending on the type of material of the composition according to one embodiment of the present invention, the type of semiconductor device to be manufactured, and the like. However, typically the metal die temperature is 170 to 180°C, and the molding time can be selected according to the metal die temperature and curability, but can generally be set to 10 to 600 seconds or 30 to 120 seconds. Furthermore, after initial curing, post-curing or heat treatment may be performed for a period ranging from a few seconds to several hours to complete the curing reaction.

Furthermore, using the sheet-like composition described above, a semiconductor device can be manufactured by flip-chip mounting, for example, as follows. In other words, the sheet-like composition can be placed on an electrode surface side of a semiconductor element provided with bonding bumps, or on a bump bonding side of a circuit board, and the semiconductor element and the circuit board can be bump-bonded together, and the two can be adhesively sealed by resin sealing to manufacture a semiconductor device by flip-chip mounting.

### EXAMPLES

The present invention is further described below on the basis of Examples, but the present invention is not limited to the Examples below. In the compositional formulas below, Me represents a methyl (-CH₃) group, an Me₃SiO group (or Me₃Si group) is denoted as "M", an Me₂SiO group as "D", and an MeHSiO group as "D^{H}". Units in which the methyl groups in M and D are modified with any substitution group are denoted as "M^{R}" and "D^{R}", respectively.

### Synthesis of Co-modified Silicone

Each property was measured using the following methods.

### GPC Peak Top Molecular Weight

GPC analysis was performed using THF as an eluting solvent, ACQUITY APC XT Columns (#186007253 x1 + #186007003 x1 + #186006995 x2) manufactured by Waters as a column, and a radioisotope detector. The peak top molecular weight was determined using a calibration curve with standard polystyrene.

### Viscosity

The viscosity of the composition at 25°C was measured using a VISCOMIC EMD E-type viscometer manufactured by Tokyo Keiki Inc.

### Volatile Content (105°C)

Determined from the amount of sample remaining after 1 g of the sample was weighed into an aluminum dish having a diameter of 6 cm, and then heated at 105°C for 1 hour.

### Volatile Content (175°C)

Determined from the amount of sample remaining after 1 g of the sample was weighed into an aluminum dish having a diameter of 6 cm, and then heated at 175°C for 3 hours.

### ¹³C-NMR and ²⁹Si-NMR Analysis

The analyses were performed using ECA500 manufactured by JEOL and deuterated benzene as a measurement solvent.

### Synthesis Example 1 (Example): Synthesis of Phenol-Polyether-Modified Silicone

Step 1: 433.7 g of methylhydrogenpolysiloxane expressed by the average compositional formula: MD_{61.9}DH_{5.8}M, 712.9 g of allyl polyether expressed by the average compositional formula: CH₂=CH-CH₂-O-(C₂H₄O)₁₈(C₃H₆O)₂₅-CH₃, and 120.0 g of toluene were charged into a reactor. Under a nitrogen flow, 0.81 g of a toluene solution of a platinum-1,3-divinyl-1,1,3,3-tetramethyldisiloxane complex (Pt concentration: 0.3 wt.%) was added at 25°C while stirring. The reaction liquid was heated to 85 to 95°C and reacted for five hours, after which 2 g was collected and the reaction rate was confirmed to not be a problem using an alkali decomposition gas generation method.

Step 2: 53.9 g of 2-allylphenol (manufactured by Tokyo Chemical Industry Co., Ltd.) and 0.39 g of the same platinum catalyst solution as above were added to the reaction liquid. The reaction was performed at 85 to 95°C for four hours, and after performing confirmation using the same method, the reaction was complete. Step 3: Low-boiling-point components such as toluene and unreacted substances were removed by distillation under reduced pressure at 130 to 160°C. Further filtration yielded 1090 g of a composition containing phenol-polyether-modified silicone 1, which is expressed by the structure below, as a light brown homogeneous liquid. Note that the following structure was determined from ¹³C-NMR and ²⁹Si-NMR. The molecular weight was determined as the GPC peak top molecular weight.

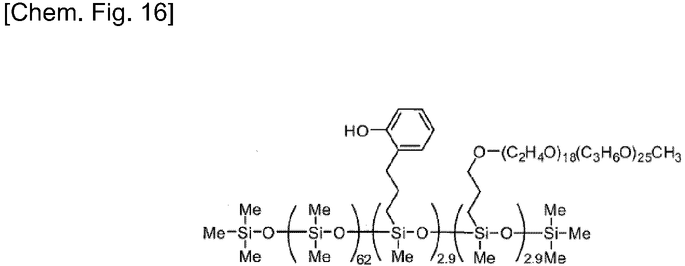

### Synthesis Example 2 (Example): Synthesis of Phenol-Polyether-Modified Silicone

Step 1: 154.7 g of methylhydrogenpolysiloxane expressed by the average compositional formula: MD_{54.4}DH_{7.7}M, 3.0 g of α-methylstyrene (manufactured by Fujifilm Wako Pure Chemical Industries), 22.1 g of vinyltrimethylsiloxysilane expressed by the average compositional formula: CH₂=CH-Si(OSiMe₃)₃, and 500.0 g of toluene were charged into a reactor. Under a nitrogen flow, 0.42 g of a toluene solution of a platinum-1,3-divinyl-1,1,3,3-tetramethyldisiloxane complex (Pt concentration: 0.3 wt.%) was added at 25°C while stirring. The reaction liquid was heated to 70 to 80°C and reacted for five hours, after which 2 g was collected and the reaction rate was confirmed to not be a problem using an alkali decomposition gas generation method.

Step 2: 311.1 g of allyl polyether expressed by the average compositional formula: CH₂ = CH-CH₂-O-(C₂H₄O)₁₈(C₃H₆O)₂₅-CH₃ and 0.21 g of the same platinum catalyst solution as above were added to the reaction liquid. The reaction liquid was heated to 80 to 100°C and reacted for five hours, after which 2 g was collected and the reaction rate was confirmed to not be a problem using an alkali decomposition gas generation method.

Step 3: 37.0 g of 2-allylphenol (manufactured by Tokyo Chemical Industry Co., Ltd.) and 1.26 g of the same platinum catalyst solution as above were added to the reaction liquid. The reaction was performed at 90 to 120°C for five hours, and after performing confirmation using the same method, the reaction was complete. Step 4: Low-boiling-point components such as toluene and unreacted substances were removed by distillation under reduced pressure at 130 to 175°C. Further filtration yielded 896 g of a composition containing phenol-polyether-modified silicone 2, which is expressed by the structure below, as a brown homogeneous liquid. Note that the following structure was determined from ¹³C-NMR and ²⁹Si-NMR. The molecular weight was determined as the GPC peak top molecular weight.

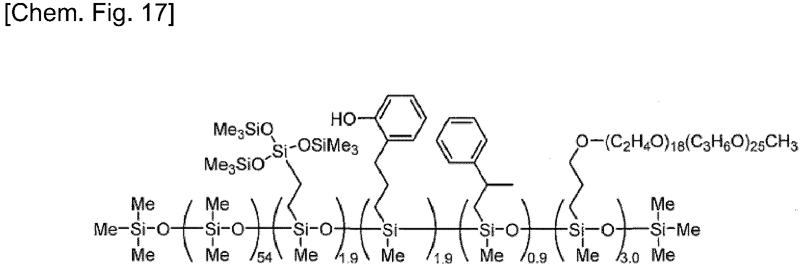

### Synthesis Example 3 (Example): Synthesis of Phenol-Polyether-Modified Silicone

Step 1: 154.3 g of methylhydrogenpolysiloxane expressed by the average compositional formula: MD_{54.4}DH_{7.7}M, 22.1 g of vinyltrimethylsiloxysilane expressed by the average compositional formula: CH₂ = CH-Si(OSiMe₃)₃, and 500.0 g of toluene were charged into a reactor. Under a nitrogen flow, 0.21 g of a toluene solution of a platinum-1,3-divinyl-1,1,3,3-tetramethyldisiloxane complex (Pt concentration: 0.3 wt.%) was added at 25°C while stirring. The reaction liquid was heated to 70 to 80°C and reacted for three hours, after which 2 g was collected and the reaction rate was confirmed to not be a problem using an alkali decomposition gas generation method.

Step 2: 308.0 g of allyl polyether expressed by the average compositional formula: CH₂ = CH-CH₂-O-(C₂H₄O)₁₈(C₃H₆O)₂₅-CH₃ and 0.67 g of the same platinum catalyst solution as above were added to the reaction liquid. The reaction liquid was heated to 70 to 80°C and reacted for five hours, after which 2 g was collected and the reaction rate was confirmed to not be a problem using an alkali decomposition gas generation method.

Step 3: 40.0 g of 2-allylphenol (manufactured by Tokyo Chemical Industry Co., Ltd.) and 0.84 g of the same platinum catalyst solution as above were added to the reaction liquid. The reaction was performed at 90 to 120°C for five hours, and after performing confirmation using the same method, the reaction was complete. Step 4: Low-boiling-point components such as toluene and unreacted substances were removed by distillation under reduced pressure at 120 to 180°C. Further filtration yielded 848 g of a composition containing phenol-polyether-modified silicone 3, which is expressed by the structure below, as a brown homogeneous liquid. Note that the following structure was determined from ¹³C-NMR and ²⁹Si-NMR. The molecular weight was determined as the GPC peak top molecular weight.

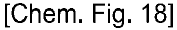

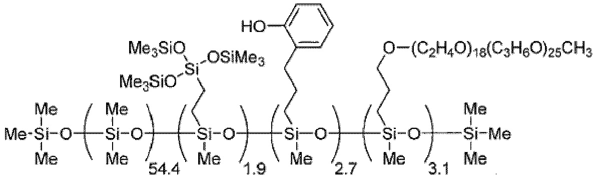

### Synthesis Example 4 (Example): Synthesis of Phenol-Polyether-Modified Silicone

Step 1: 153.4 g of methylhydrogenpolysiloxane expressed by the average compositional formula: MD_{54.4}DH_{7.7}M, 21.9 g of vinyltrimethylsiloxysilane expressed by the average compositional formula: CH₂ = CH-Si(OSiMe₃)₃, and 500.0 g of toluene were charged into a reactor. Under a nitrogen flow, 0.20 g of a toluene solution of a platinum-1,3-divinyl-1,1,3,3-tetramethyldisiloxane complex (Pt concentration: 0.3 wt.%) was added at 25°C while stirring. The reaction liquid was heated to 70 to 80°C and reacted for three hours, after which 2 g was collected and the reaction rate was confirmed to not be a problem using an alkali decomposition gas generation method.

Step 2: 308.0 g of allyl polyether expressed by the average compositional formula: CH₂ = CH-CH₂-O-(C₂H₄O)₁₈(C₃H₆O)₂₅-CH₃ and 0.44 g of the same platinum catalyst solution as above were added to the reaction liquid. The reaction liquid was heated to 70 to 80°C and reacted for five hours, after which 2 g was collected and the reaction rate was confirmed to not be a problem using an alkali decomposition gas generation method.

Step 3: 40.0 g of eugenol (manufactured by FUJIFILM Wako Pure Chemical Corporation) and 1.53 g of the same platinum catalyst solution as above were added to the reaction liquid. The reaction was performed at 90 to 120°C for five hours, and after performing confirmation using the same method, the reaction was complete.

Step 4: Low-boiling-point components such as toluene and unreacted substances were removed by distillation under reduced pressure at 120 to 190°C. Further filtration yielded 853 g of a composition containing phenol-polyether-modified silicone 4, which is expressed by the structure below, as a brown homogeneous liquid. Note that the following structure was determined from ¹³C-NMR and ²⁹Si-NMR. The molecular weight was determined as the GPC peak top molecular weight.

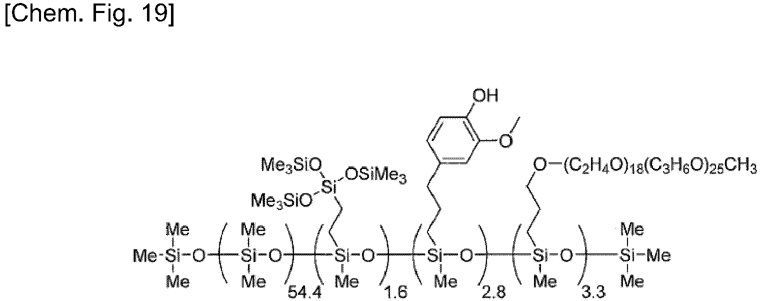

Table 1 depicts the structural information of the compounds synthesized in Synthesis Examples 1 to 4. Note that for comparison, DOWSIL (trade mark) FZ-3736 (epoxy-polyether-modified silicone manufactured by Dow-Toray, viscosity: 2360 mPa·s), which was prepared as a comparative compound, had a volatile content of 0.5% at 105°C and a volatile content of 66.1% at 175°C.

**[Table 1]**

| | | Synthesis Example 1 (Examples) | Synthesis Example 3 (Examples) | Synthesis Example 4 (Examples) | Synthesis Example 5 (Examples) |
|---|---|---|---|---|---|
| Structures Determined from ¹³C-NMR and ²⁹Si-NM^{R} | M | 2 | 2 | 2 | 2 |
| | D | 61.9 | 54.4 | 54.4 | 54.4 |
| | 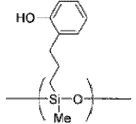 | 2.9 | 1.9 | 2.7 | |
| | 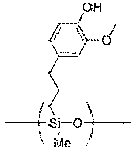 | 0 | 0 | 0 | 2.8 |
| | 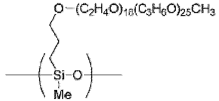 | 2.9 | 3.0 | 3.1 | 3.3 |
| | 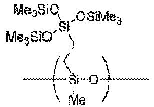 | 0 | 1.9 | 1.9 | 1.6 |
| Analytical Values | Viscosity (10 rpm), mPa·s | 2,270 | 2,520 | 2,380 | 2,490 |
| | Volatile content (105°C) | 0.6% | 0.5% | 0.1% | 0.2% |
| | Volatile content (175°C) | 15.8% | 20.1% | 21.0% | 19.8% |
| | Peak top molecular weight | 23,600 | 23,000 | 24,100 | 20,300 |

When comparing the heat resistance of the compounds in Synthesis Examples 1 to 4 with that of the comparative compound, all of the compounds of Synthesis Examples 1 to 4 had nearly 0% volatile content (at 105°C), indicating low volatile components. However, in Comparative Example 1, nearly 66% was lost at 175°C. On the other hand, the co-modified silicones of Synthesis Examples 1 to 4, which have phenolic hydroxyl groups, have volatile contents suppressed to about 15 to 20%, making the co-modified silicone suitable for use in high-temperature environments.

### Curable Resin Composition Preparation

The components in the added amounts (parts by mass) listed in Table 2 were mixed at ambient temperature using a mixer to obtain a mixture. Next, the mixture was heated and kneaded at a temperature from 70°C to 110°C. The mixture was then cooled to ambient temperature to obtain a curable resin composition.

Details of each raw material component are as follows.

### Epoxy Resins

- Epoxy resin 1: Biphenyl-type epoxy resin (Mitsubishi Chemical Corporation, product number: YX-4000H)
- Epoxy resin 2: Mixture of trisphenylmethane-type epoxy resin (75 mass%) and biphenyl-type epoxy resin (25 mass%) (Mitsubishi Chemical Corporation, product number: YL6677)

### Curing Agent

- Curing agent 1: Trisphenylmethane-type phenolic resin (Air Water Inc., HE910-20)

### Inorganic Fillers

- Inorganic filler 1: Spherical silica with average particle size of 19 µm (Nippon Steel & Sumikin Metal Materials Co., Ltd., Micron Company, product number: S430-5)
- Inorganic filler 2: Spherical silica with average particle size of 0.5 µm (Admatechs Co., Ltd., product number: SC-2500-SQ)
- Inorganic filler 3: Spherical silica with average particle size of 1.5 µm (Admatechs Co., Ltd., product number: SC-5500-SQ)

### Curing Accelerators

- Curing accelerator 1: 2,3-dihydroxynaphthalene (Tokyo Chemical Industries, Ltd.)
- Curing accelerator 2: Triphenylphosphine (Tokyo Chemical Industries Co., Ltd.)

### Coupling Agent

- Coupling agent 1: N-phenyl-3-aminopropyltrimethoxysilane (Dow-Toray Industries, Ltd., Z-6883)

### Mold Release Agent

- Mold release agent: Glycerin trimontanoate (Clariant Japan Co., Ltd., LICOLUB WE-4)

Co-modified silicone compounds: As an example, the phenol-polyether-modified silicone of Synthesis Example 1 was used, and as a comparative example, DOWSIL (trade mark) FZ-3736 (epoxy-polyether-modified silicone manufactured by Dow-Toray) of Comparative Example 1 was used.

### Evaluation of Mechanical Properties of Cured Products

Each prepared curable resin composition was cured using the following method, and the mechanical properties of the resulting cured products were evaluated.

### Cured Product Preparation

Cured products were prepared using each of the curable resin compositions listed in Table 2. A metal die having upper, middle, and lower dies was used for molding. For the middle die, a metal die cut to a size of 100 mm x 10 mm x 4 mm was used. A quantity of a curable resin composition corresponding to the volume of the cut-out section of the middle die was placed on top of the lower die, and then sandwiched by the upper die. Molding was performed using a manual hydraulic heating press under the conditions of a metal die temperature of 175°C at 2.4 MPa, and a curing time of 10 minutes, yielding a test piece measuring 100 mm in length, 10 mm in width, and 4 mm in thickness. Next, the obtained test pieces were heat-treated at 175°C for four hours, and then allowed to cool. On the basis of the above, cured products for evaluation were prepared.

### Coefficient of Linear Expansion of Cured Product

The coefficient of linear expansion of cured products measuring 4 mm x 4 mm x 10 mm was measured using a thermomechanical analyzing device (TMA7100, manufactured by Hitachi High-Tech Science Corporation). The measurements were performed under conditions of heating from -30°C to 300°C at a heating rate of 5°C/min. The measurement data was analyzed, and the average coefficient of linear expansion [ppm/°C] between 0°C and 140°C was defined as CTE1, and the average coefficient of linear expansion [ppm/°C] between 180°C and 220°C was defined as CTE2.

### Flexural Modulus of Elasticity and Flexural Strength of Cured Products

For a cured product measuring 100 mm in length, 10 mm in width, and 4 mm in thickness, the flexural modulus of elasticity [MPa (N/mm²)] and flexural strength [MPa (N/mm²)] at 25°C were evaluated using a tensile testing machine (manufactured by Shimadzu Corporation, AGS-X, 10N-10kN).

### Spiral Flow Evaluation

Using a transfer molding machine (manufactured by Takara Seisakusho Co., Ltd.), the resin compositions of each example were injected and cured in a metal die for spiral flow measurement in accordance with ASTM D3123-09, under conditions of a metal die temperature of 175°C, an injection pressure of 12 MPa, and pressure keeping time of 180 seconds, and the spiral flow was measured. The unit of measurement for spiral flow is cm.

The curable resin composition containing a co-modified silicone compound that does not have a phenolic hydroxyl group (Comparative Example 2) yielded 141.0 cm, while the curable resin composition containing a phenol/polyether-modified silicone (Example 1) yielded 162.6 cm.

As listed in Table 2 and the results described above, the evaluation using the curable resin composition containing the phenol-polyether-modified silicone (Example 1) yielded favorable results, with a low modulus of elasticity, CTE1, and CTE2, and excellent fluidity (flowability) during molding. On the other hand, in the curable resin composition that did not contain a co-modified silicone compound (Comparative Example 1), high values were obtained for both the modulus of elasticity, CTE1, and CTE2. Furthermore, in the evaluation of the curable resin composition containing a co-modified silicone compound that does not have a phenolic hydroxyl group (Comparative Example 2), although the modulus of elasticity decreased, the reduction effect of CTE1 and CTE2 was insufficient, and the fluidity during molding was inferior.
Note that although the evaluation in Example 1 was intended for sealing a semiconductor package or the like, application is also possible to underfills and other resin compositions.

**[Table 2]**

| Component | | | Example 1 | Comparative Example 1 | Comparative Example 2 |
|---|---|---|---|---|---|
| Epoxy Resin | Epoxy resin 1 | | 3.51 | 4.48 | 3.51 |
| | Epoxy resin 2 | | 3.52 | 4.49 | 3.52 |
| Curing Agent | Curing agent 1 | | 3.88 | 4.95 | 3.88 |
| Inorganic Filler | Inorganic filler 1 | | 70.12 | 70.04 | 70.12 |
| | Inorganic filler 2 | | 7.02 | 7.01 | 7.02 |
| | Inorganic filler 3 | | 8.02 | 8.02 | 8.02 |
| Curing Accelerator | Curing accelerator 1 | | 0.17 | 0.22 | 0.17 |
| | Curing accelerator 2 | | 0.15 | 0.19 | 0.15 |
| Coupling Agent | Coupling agent 1 | | 0.40 | 0.40 | 0.40 |
| Mold Release Agent | Mold release agent 1 | | 0.20 | 0.20 | 0.20 |
| Co-Modified Silicone | Synthesis Example 1 | | 3.01 | 0 | 0 |
| | DOWSIL(Trade mark) FZ-3736 | | 0 | 0 | 3.01 |
| Flexural modulus of elasticity [MPa] | | | 8,900 | 12,800 | 8,200 |
| Flexural strength [MPa] | | | 66 | 134 | 60 |
| Coefficient of linear expansion | CTE 1 | | 7.6 | 11.7 | 10.5 |
| | | [ppm/°C] | | | |
| Coefficient of linear expansion | CTE 2 | | 7.9 | 40.8 | 21.9 |
| | | [ppm/°C] | | | |

## Claims

1. A co-modified silicone, including, in a molecule: a phenolic hydroxyl group-containing structure; and a polyether structure.

2. The co-modified silicone according to claim 1, wherein the viscosity at 25°C is in the range from 50 to 100,000 mPa·s.

3. The co-modified silicone according to claim 1, which is expressed by average compositional formula (1):
R¹ₐR²_{b}R³_{c}R⁴_{d}SiO_{(4-a-b-c-d)/2},
wherein
in the abovementioned average compositional formula (1), R¹ each independently represents a hydrogen atom or a monovalent hydrocarbon group with 1 to 18 carbon atoms, R² each independently represents a group having a phenolic hydroxyl group expressed by general formula (2) below, R³ each independently represents a group containing a polyether structure expressed by general formula (3) below, and R⁴ each independently represents a monovalent hydrocarbon group with 1 to 18 carbon atoms or a silicon-containing organic group; and
a, b, c, and d satisfy the relationships of b > 0, c > 0, a ≥ 0, d ≥ 0, and a + b + c + d = 4. 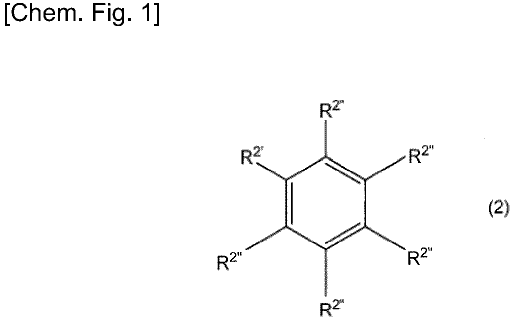
(In general formula (2),
R^{2***'***} represents a divalent hydrocarbon group with 1 to 18 carbon atoms bonded to a silicon atom, and
R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group.) 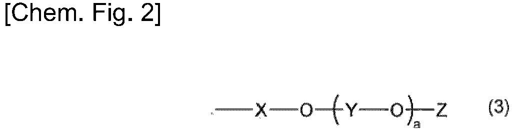
(In general formula (3),
X represents a divalent hydrocarbon group with 1 to 18 carbon atoms,
Y represents an alkylene group with 1 to 6 carbon atoms,
a represents a number from 5 and 100, and
Z represents a hydrogen atom, a monovalent hydrocarbon group with 1 to 12 carbon atoms, or an acyl group with 1 to 12 carbon atoms.)

4. A co-modified silicone expressed by average composition formula (2):
(R¹₂R'SiO_{1/2})ₐ(R²R'SiO_{2/2})_{b}(R³R'SiO_{2/2})_{b'}(R⁴R'SiO_{2/2})_{b"}(R'SiO_{3/2})_{c}(SiO_{4/ 2})_{d},
wherein
in the abovementioned average composition formula (2), R¹ each independently represents a hydrogen atom or a monovalent hydrocarbon group with 1 to 18 carbon atoms, R² each independently represents a group having a phenolic hydroxyl group expressed by general formula (2) below, R³ each independently represents a group containing a polyether structure expressed by general formula (3) below, R⁴ each independently represents a monovalent hydrocarbon group with 1 to 18 carbon atoms or a silicon-containing organic group, and R' each independently represents one of R¹, R², R³, or R⁴; and
a, b, b', b", c, and d satisfy the relationships of b > 0, b' > 0, a ≥ 0, b" ≥ 0, c ≥ 0, d ≥ 0, and 20 ≤ a + b + b' + b" + c + d ≤ 1000. 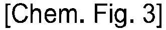 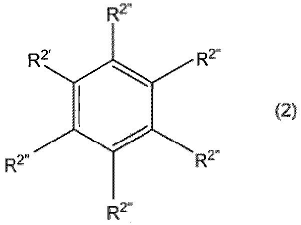
(In general formula (2),
R^{2***'***} represents a divalent hydrocarbon group with 1 to 18 carbon atoms bonded to a silicon atom, and
R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group.) 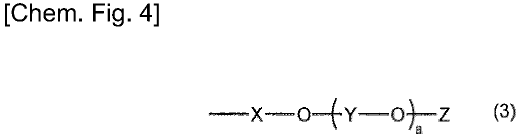
(In general formula (3),
X represents a divalent hydrocarbon group with 1 to 18 carbon atoms,
Y represents an alkylene group with 1 to 6 carbon atoms,
a represents a number from 5 to 100, and
Z represents a hydrogen atom, a monovalent hydrocarbon group with 1 to 12 carbon atoms, or an acyl group with 1 to 12 carbon atoms.)

5. The co-modified silicone according to claim 1, comprising a structure expressed by the following general formula (1). 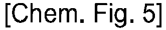 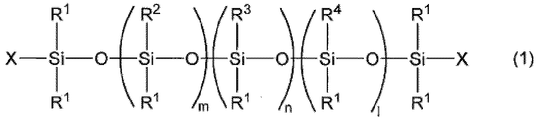 (In general formula (1),
R¹ each independently represents a hydrogen atom or a monovalent hydrocarbon group with 1 to 18 carbon atoms,
R² each independently represents a group having a phenolic hydroxyl group expressed by general formula (2) below,
R³ each independently represents a group containing a polyether structure expressed by general formula (3) below,
R⁴ each independently represents a monovalent hydrocarbon group or silicon-containing organic group with 1 to 18 carbon atoms,
X each independently represents one of R¹, R², R³, or R⁴,
m represents a number from 0 to 100, where if m = 0, at least one X is R²,
n represents a number from 0 to 100, where if n = 0, at least one X is R³,
when m = n = 0, two Xs in a molecule are R² and R³, respectively, and
l represents a number from 0 to 1000.) 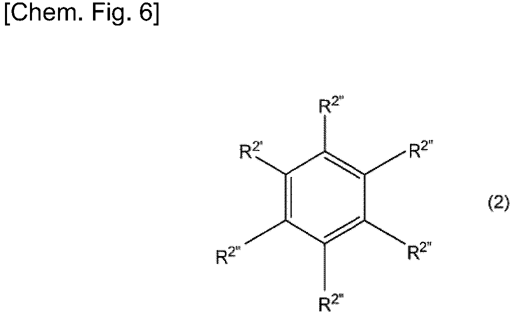
(In general formula (2),
R^{2***'***} represents a divalent hydrocarbon group with 1 to 18 carbon atoms bonded to a silicon atom, and
R^{2"} each independently represents a hydrogen atom, a hydroxyl group, a monovalent hydrocarbon group with 1 to 6 carbon atoms, or an alkoxy group with 1 to 6 carbon atoms, provided that at least one of the R^{2"} is a hydroxyl group.) 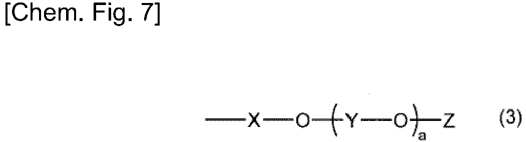
(In general formula (3),
X represents a divalent hydrocarbon group with 1 to 18 carbon atoms,
Y represents an alkylene group with 1 to 6 carbon atoms,
a represents a number from 5 to 100, and
Z represents a hydrogen atom, a monovalent hydrocarbon group with 1 to 12 carbon atoms, or an acyl group with 1 to 12 carbon atoms.)

6. An additive for an organic resin, the additive comprising the co-modified silicone according to any one of claims 1 to 5.

7. The additive for an organic resin according to claim 6, wherein the organic resin includes an epoxy resin.

8. A curable resin composition, comprising the co-modified silicone according to any one of claims 1 to 5.

9. The curable resin composition according to claim 8, wherein the curable resin includes an epoxy resin.

10. A cured product obtained by curing the curable resin composition according to claim 8 or 9.

11. A semiconductor device, comprising the cured product according to claim 10.

12. A method for manufacturing a semiconductor device, the method comprising curing the curable resin composition according to claim 8 or 9.
